# EUROPEAN PATENT APPLICATION

(11) **EP 4 539 104 A1**
(43) Date of publication of application: **16.04.2025**
(21) Application number: 23819592.9
(22) Date of filing: 15.05.2023
(51) Int. Cl.: H01L 21/304, B23H 5/00, C25F 3/16

(54) **SURFACE TREATMENT METHOD**

(30) Priority: 08.06.2022 JP 2022093027
(71) Applicant: DENSO CORPORATION, Kariya-city, Aichi 448-8661 (JP)
(72) Inventor: AOKI, Kazufumi, Kariya-city, Aichi 448-8661 (JP); MARUNO, Naoki, Kariya-city, Aichi 448-8661 (JP); SOLTANI, Bahman, Kariya-city, Aichi 448-8661 (JP); HORI, Kantaro, Kariya-city, Aichi 448-8661 (JP); FURUKAWA, Ryuta, Kariya-city, Aichi 448-8661 (JP); KATO, Yuya, Kariya-city, Aichi 448-8661 (JP)
(74) Representative: Kuhnen & Wacker Patent- und Rechtsanwaltsbüro PartG mbB
(86) International application number: PCT/JP2023/018139
(87) International publication number: WO 2023/238608

(57) **Abstract**

A surface processing method for planarizing a processing surface (W1) of a workpiece (W) includes the following procedures, treatments, or processes. With a wheel layer (32) and the processing surface of the workpiece facing each other with an alkaline electrolyte solution (S) between them, an oxide is formed on the processing surface of the workpiece by anodic oxidation by passing a current through the workpiece as an anode. The oxide formed on the processing surface by the anodic oxidation is removed by using the wheel layer.

## Description

### [Cross-Reference to Related Application]

The present application is based on Japanese Patent Application No. 2022-093027 filed on June 8, 2022, the entire contents of which are hereby incorporated by reference.

### [Technical Field]

The present disclosure relates to a surface processing method for planarizing a processing surface of a workpiece.

### [Background Art]

Patent Literature 1 provides a method of polishing with anodic oxidation that enables highly efficient processing of difficult-to-process materials, such as single-crystal SiC, into a desired shape with a scratch-free, damage-free, and high-grade surface. Specifically, the polishing method disclosed in Patent Literature 1 includes an anodizing process and a polishing process. The anodizing process is a process that forms an oxide film on the surface of the workpiece by applying a voltage to the workpiece as an anode in the presence of an electrolyte solution and passing a current of a predetermined current density. The polishing process selectively removes the oxide film by using an abrasive material whose Mohs hardness is intermediate between that of the workpiece and the oxide film. The polishing method disclosed in Patent Literature 1 performs the anodizing process and the polishing process simultaneously to planarize the surface of the workpiece. The polishing method disclosed in Patent Literature 1 is included in a technique referred to as ECMP. ECMP stands for an electro-chemical mechanical polishing.

### [Citation List]

### [Patent Literature]

[PTL 1] JP 2017-92497 A

### [Summary of the Invention]

The inventors have studied the matter intensively. As a result, they found that in conventional ECMP, many scratches occur on the processing surface, resulting in increasing surface roughness when increasing a processing speed. The inventors also considered the factors and found the following viewpoints. For example, agglomerated sludge adheres to the workpiece or a wheel (whetstone) and then is stuck into a processing interface. This causes scratching. For example, a hardness of the oxide film generated by the anodic oxidation requires high pressure during processing. This distorts the processing surface and causes scratching.

This disclosure was made in light of the above-mentioned circumstances and other factors. In other words, the present disclosure provides, for example, a technique that enables a high processing speed and suitable surface roughness in surface processing methods (e.g., grinding, rough grinding, or polishing) with the anodic oxidation.

According to an aspect of the present disclosure, a surface processing method is a method of planarizing a processing surface of a workpiece, and includes the following procedures, treatments, or processes. With a wheel layer and the processing surface of the workpiece facing each other with an alkaline electrolyte solution between them, an oxide is formed on the processing surface of the workpiece by anodic oxidation by passing a current through the workpiece as an anode. The oxide formed on the processing surface by the anodic oxidation is removed by using the wheel layer.

Each element may be marked with the bracketed reference signs in the various paragraphs in this description. In this case, the reference signs indicate one example of the correspondence between the same element and the specific configuration described in the embodiment below. Therefore, this disclosure is not limited by the reference signs.

### [Brief Description of the Drawings]

FIG. 1 shows a schematic diagram of a surface processing apparatus for performing a surface processing method in accordance with an embodiment of the present disclosure.
FIG. 2 is a plan view showing a position for measuring a surface roughness of a processing surface after polishing in examples and comparative examples.
FIG. 3 is a graph showing the results of measuring the surface roughness of the processing surface after polishing in the examples and comparative examples.
FIG. 4 is a graph showing the results of measuring a hardness of an oxide film formed on the processing surface in the examples and comparative examples.
FIG. 5 is a graph showing a polishing speed in ECMP of a SiC wafer as a workpiece according to the examples and comparative examples.
FIG. 6 is a graph showing the polishing speed in ECMP of a SiO₂ optical glass as the workpiece in the examples and comparative examples.
FIG. 7 is a graph showing a variation in the polishing speed when varying the pH of an electrolyte solution.
FIG. 8 is a graph showing a variation in a removal capacity of silica particles as foreign matter when varying the pH of the electrolyte solution.
FIG. 9 is a graph showing a variation in the removal capacity of ceria particles as foreign matter when varying the pH of the electrolyte solution.

### [Description of Embodiments]

### (Embodiment)

The following is a description of an embodiment of the present disclosure based on the drawings. Various modifications applicable to one embodiment may hinder understanding if they are described during a series of explanations about the embodiment. For this reason, the modifications will not be described during the series of explanations regarding the embodiment; instead, they will be described collectively afterward.

### (Surface Processing Apparatus)

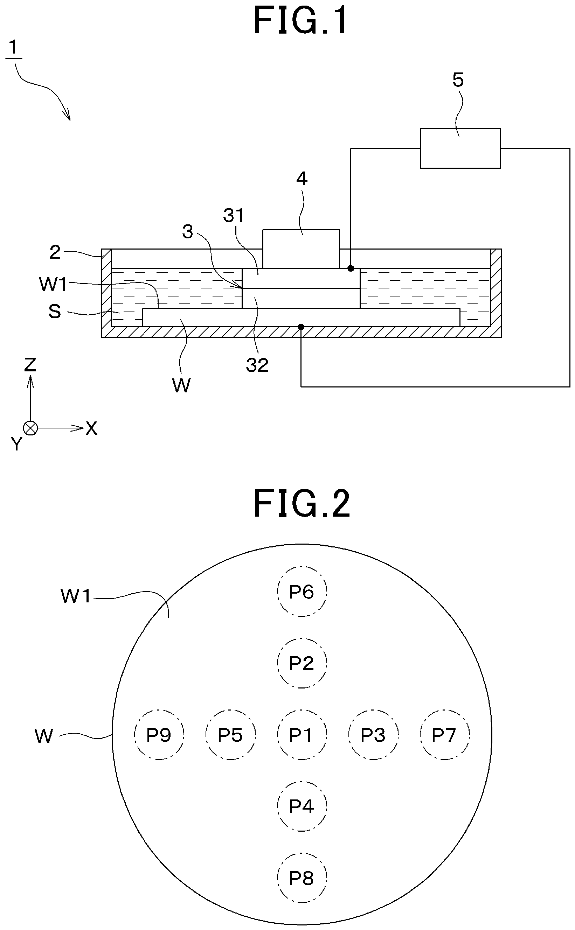

Referring to FIG. 1, a surface processing apparatus 1 is configured to enable the planarization of a processing surface W1, which is one of major surfaces of a workpiece W. The term "planarization" refers to processes such as grinding or polishing. Specifically, it is, for example, rough grinding, finish grinding, rough polishing, or finish polishing. The term "major surface" refers to a surface of a layer or plate that is perpendicular to a direction of the thickness and is also referred to as the "plate surface." Specifically, in this embodiment, the surface processing apparatus 1 is configured to enable the preformation of a planarization processing with anodic oxidation on the processing surface W1 of the workpiece W. In other words, the surface processing apparatus 1 has a configuration as an ECMP or ECMG device. ECMG stands for an electro-chemical mechanical grinding. The workpiece W is, for example, a silicon-based material, typically a semiconductor material such as a silicon carbide semiconductor.

The surface processing apparatus 1 includes a container 2, a surface processing pad 3, a drive unit 4, and a power supply unit 5. As described below, FIG. 1 and the following description referenced therein are simplified exclusively for brevity in the description of the surface processing method according to this embodiment. Therefore, the surface processing apparatus 1 does not necessarily correspond to a specific equipment configuration that is actually manufactured and sold. For simplicity of explanation, the XYZ coordinate defined according to the right-hand system is set as shown in the figure. In this embodiment, a positive direction of a Z-axis is vertically upward, i.e., opposite the direction of the gravitation. X-axis and Y-axis directions, which are orthogonal to each other, both indicate the horizontal direction. For the convenience of explanations, the Z-axis positive direction, which corresponds to a vertical upward direction, may be referred to simply as "upward," while an opposite direction may be referred to simply as "downward."

A container 2 is formed in a bathtub shape that opens upward. The container 2 is configured to accommodate the workpiece W by holding it at a bottom and dipping it in an electrolyte solution S that does not contain an etchant component. The etchant component is a component that constitutes a dissolving solution capable of dissolving an oxide film (i.e., oxide formed in a film form) on a processing surface W1 by the anodic oxidation. The etchant component is, for example, hydrofluoric acid. In this embodiment, the electrolyte solution S, without the etchant component, is an alkaline electrolyte solution with a pH range of 9 to 13. For example, potassium hydroxide, sodium hydroxide, lithium hydroxide, or calcium hydroxide can be used as a basic compound to adjust the pH of the electrolyte solution S to between 9 and 13. The surface processing pad 3 and drive unit 4 are located above the container 2. An unshown lifting mechanism allows the container 2, the surface processing pad 3, and the drive unit 4 to move vertically relative to one another. An unshown slide mechanism allows the container 2, the surface processing pad 3, and the drive unit 4 to move horizontally relative to one another (that is, to move in an in-plane direction relative to one another).

The surface processing pad 3 has an electrode 31 and a wheel layer 32. The electrode 31 is a plate-shaped member made of metal or another conductor. The electrode 31 is formed by, for example, a copper plate. The grinding wheel layer 32 is joined to the electrode 31. In other words, the surface processing pad 3 has a configuration in which the electrode 31 and the wheel layer 32 are joined in a thickness direction of the surface processing pad 3. The wheel layer 32 is formed by the wheel (such as a ceria wheel), which is an abrasive or grinding material. The surface processing pad 3 is provided so that the wheel layer 32 is located opposite the processing surface W1 of the workpiece W, with the electrolyte solution S between them. The surface processing pad 3 is provided to selectively polish or grind the oxide film formed on the processing surface W1 by the anodic oxidation due to being rotary driven by the drive unit 4 with the wheel layer 32 being located opposite the processing surface W1 across the electrolyte solution S.

The drive unit 4 is configured to drive the surface processing pad 3 around a rotation axis along the vertical direction (upward and downward directions). The power supply unit 5 is provided so that an anode oxidation current, which is a current for anodizing the processing surface W1, which is a target surface to be processed by the wheel layer 32, can flow by applying a voltage to the workpiece W as an anode and the electrode 31 in the surface processing pad 3 as a cathode in the presence of the electrolyte solution S.

### (Outline of Surface Processing Method for Embodiment)

The surface processing method (i.e., grinding or polishing method) of the workpiece W according to the present embodiment, is a method of planarizing the processing surface W1, which is the surface of the workpiece W, and is performed using the surface processing apparatus 1 shown in FIG. 1. Specifically, the surface processing method includes the following procedures, treatments, or processes.
(1) In this method, the oxide film is formed on the processing surface W1 by the anodic oxidation by passing the current through the workpiece W as the anode while the wheel layer 32 and the processing surface W1 are placed facing each other with the alkaline electrolyte solution S in between.
(2) In this method, the oxide film formed on the processing surface W1 by the anodic oxidation is removed by using the wheel layer 32.

With the surface processing method of the workpiece W according to the present embodiment, the oxide film formed in a film form on the processing surface W1 by the anodic oxidation has a lower hardness than a non-oxidized area on the processing surface W1. Therefore, the oxide film is selectively removed from the processing surface W1 by rubbing the processing surface W1 with the wheel layer 32. This results in a suitable planarization of the processing surface W1 to the desired a surface roughness. The generation of the oxide film by the anodic oxidation and removal of the oxide film using wheel layer 32 can be performed simultaneously or with a time lag.

According to the present embodiment, the surface processing method can be well applied, for example, to a surface planarization process of a semiconductor material such as a SiC wafer, for which the surface roughness of a nano level is required. Here, this type of surface planarization process is currently affected by lead time in the semiconductor wafer fabrication. Therefore, in this type of surface planarization process, increasing a processing speed as much as possible without decreasing processing quality will result in improved manufacturing efficiency in the semiconductor wafer fabrication. The inventors have earnestly studied this. As a result, they found that in conventional ECMP or ECMG, when trying to increase the processing speed, many scratches occur on the processing surface W1, and the surface roughness increases. The inventors also considered the factors and found the following viewpoints.

(Viewpoint 1) Agglomerated sludge is stuck into a processing interface as it adheres to the workpiece W and the wheel layer 32.

This causes scratching.

(Viewpoint 2) Due to a high hardness of the oxide film generated by the anodic oxidation, high pressure is required during processing. This distorts the processing surface W1, resulting in scratching.

Therefore, the inventors have invented a method to obtain a suitable surface roughness on the processing surface W1 while increasing the processing speed by the following mechanism to solve the above issues from the above viewpoints.

(Mechanism 1) By controlling the potentials of the processing surface W1 and the sludge, agglomeration of the sludge and adhesion of the sludge to the processing surface W1 are suppressed.

(Mechanism 2) A hardness of the oxide film generated by the anodic oxidation is reduced, and a pressure during processing is lowered, thereby suppressing occurring distortion and scratching on the processing surface W1.

To realize the above mechanism, the inventors have found a method of using an alkaline solution as the electrolyte solution S in the anodic oxidation. By using an alkaline electrolyte solution for the anodic oxidation, each zeta potential of the workpiece W and the sludge can be controlled to be unified to a negative value. This suppresses the agglomeration of the sludge, and the agglomeration of abrasive grains released from the wheel layer 32, as well as the adhesion of the sludge to the processing surface W1. It can also reduce the hardness of the oxide film generated during the anodic oxidation. This allows the oxide film to be easily removed using the wheel layer 32. The chemical reaction between the oxide film and the alkaline solution makes it possible to remove the oxide film even at a low pressure. Furthermore, a wear rate of the wheel layer 32 is reduced. Therefore, the surface processing method, according to the present embodiment, makes it possible to achieve both high processing speed and suitable surface roughness.

### (Example 1: Surface Roughness)

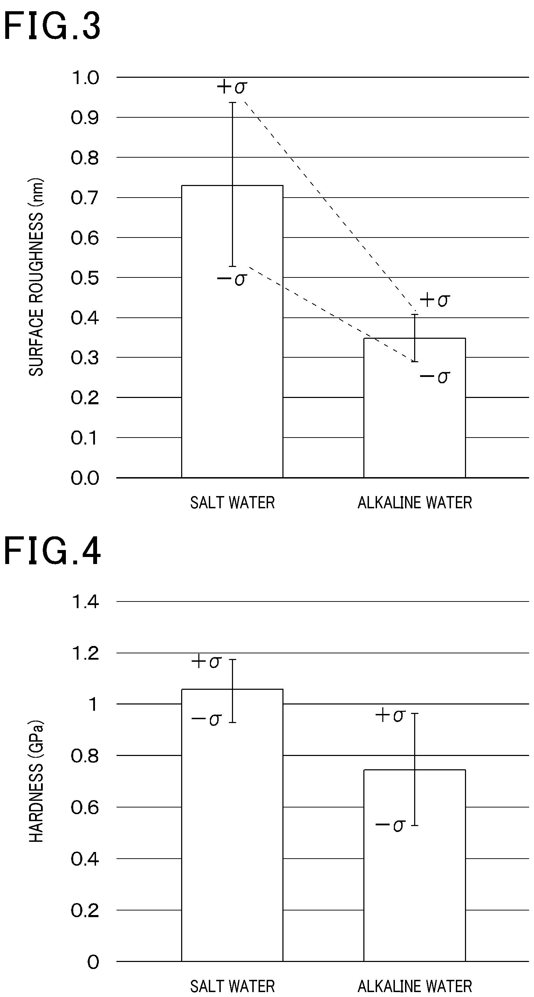

First, in ECMP using the SiC wafer as the workpiece W, we evaluated a state of finish on the processing surface W1 when salt water at the pH of 7 and alkaline electrolytic water (specifically, potassium hydroxide solution) at the pH of 12 were used as the electrolyte solution S. Specifically, the processing was performed at a current density of 10 mA/cm² in a direct current for 30 minutes. The surface roughness Ra was then measured at a total of nine points from P1 to P9 on the processing surface W1 shown in FIG. 2 using a New View 8300 scanning white light interferometer manufactured by Zygo Corporation. The measurement results are shown in FIG. 3. FIG. 3 shows an average value of the nine points as a bar graph and a variance σ, a statistic corresponding to the variation, as a vertical line segment. As shown in FIG. 3, using the alkaline electrolyte solution improves both the average surface roughness and variation in values. Visual observation showed that in the comparative examples, i.e., salt water, many scratches occurred almost all over the processing surface W1. In contrast, very little scratches occurred in Example 1, i.e., alkaline water.

### (Example 2: Oxide Film Hardness)

FIG. 4 shows the results of measuring the hardness of the oxide film formed on the processing surface W1. Conditions of the electrolyte solution S and current are the same as described above. The hardness of the oxide film was measured using a TI 980 Triboindenter manufactured by Bruker Corporation by performing the micro-Vickers hardness test, one of the hardness tests according to JIS Z 2244. An indentation depth was 200 nm. As in FIG. 3, the vertical line segment shows the variance σ, which is the statistic corresponding to the variation of the measured values at multiple points. As shown in FIG. 4, using the alkaline electrolyte solution reduced the hardness of the oxide film.

### (Example 3: Processing Speed)

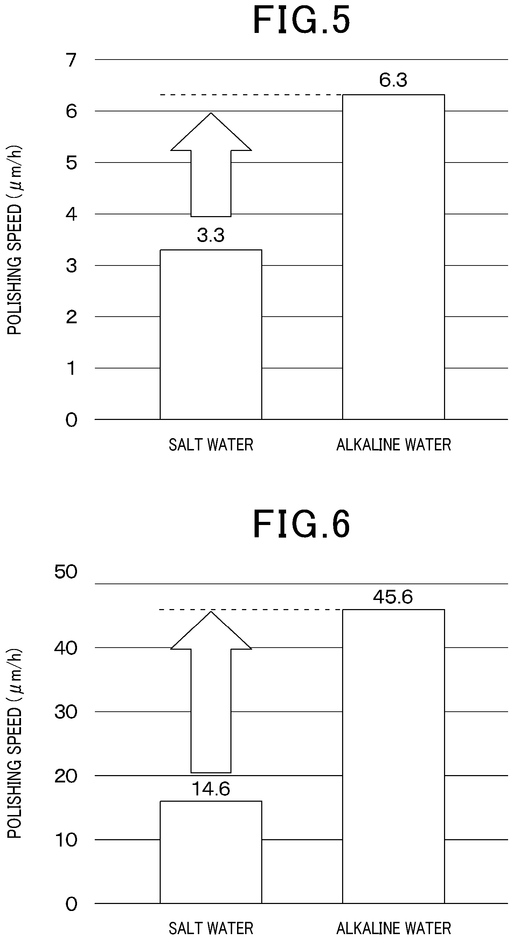

FIG. 5 shows the evaluation results of a polishing speed in ECMP using the SiC wafer as the workpiece W. FIG. 6 shows the evaluation results of the polishing speed in ECMP using a SiO₂ optical glass as the workpiece W. As shown in FIG. 5, using the alkaline electrolyte solution increased the polishing speed of the SiC wafer by about twice. As shown in FIG. 6, using the alkaline electrolyte solution increased the polishing speed of the SiO₂ optical glass by about triple. From the results above, it can be understood that the chemical reaction between the oxide film and the alkaline electrolyte solution improves the polishing speed.

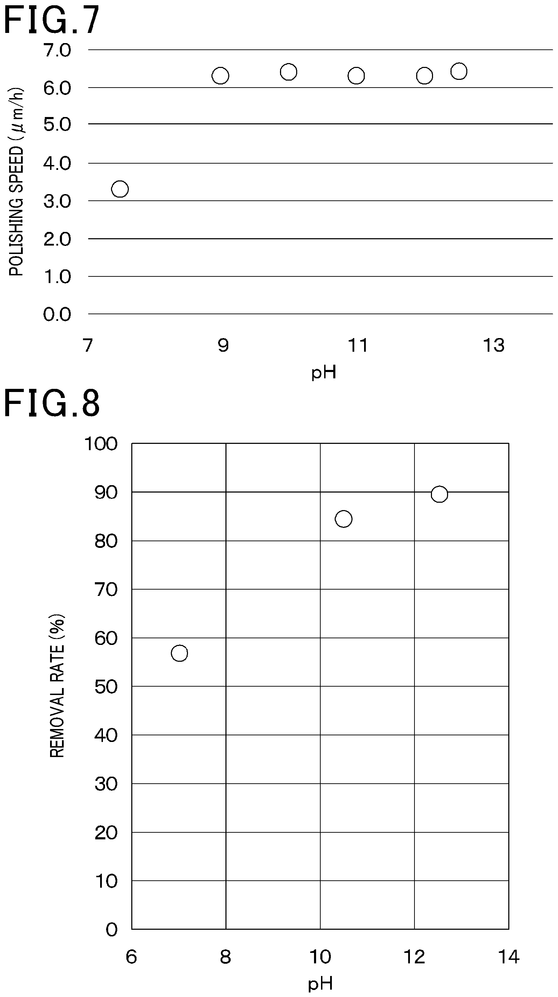

FIG. 7 shows the results of evaluating a pH dependence of the polishing speed in ECMP using the SiC wafer as the workpiece W, when the pH of the electrolyte solution S is varied. The pH of 12 or 12.5 assumes a state of a "fresh" alkaline electrolyte solution with no history of use. On the other hand, a lower pH than the above pH assumes variations in the pH over time due to the passage of processing time. As shown in FIG. 7, the polishing speed was nearly constant over the pH range of 9 to 12.5. As a result, in the case of the alkaline electrolyte solution, the polishing speed was about twice as fast as in the case of the salt water, which has the pH of about 7, i.e. It was confirmed that this can effectively suppress the occurrence of degradation of the processing speed and quality due to variations in the properties of the alkaline electrolyte solution over time.

### (Example 4: Capacity to Remove Silica Particles)

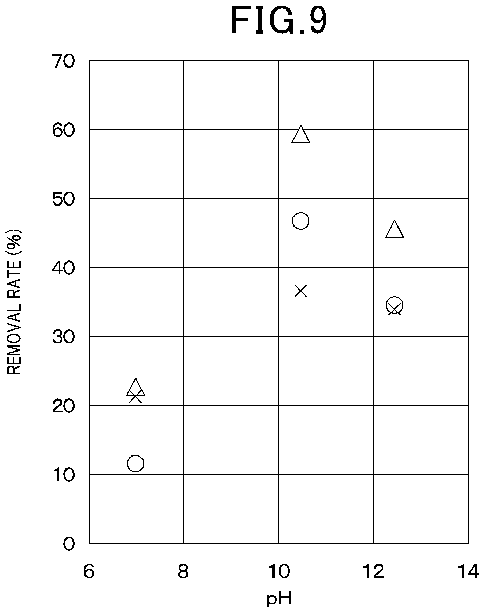

FIG. 8 shows the results of evaluating a removal rate of silica particles from the processing surface W1 in ECMP using the SiC wafer as the workpiece W. FIG. 9 shows the results of evaluating the removal rate of ceria particles from the processing surface W1 in ECMP using the SiC wafer as the workpiece W. In FIG. 9, circle signs (∘) indicate the results for a particle size of 0.2 µm. Triangle signs (△) indicate the results for the particle size of 0.3 µm. Cross signs (×) indicate the results for the particle size of 0.5 µm. The removal rate was evaluated by measuring wafer surfaces before and after processing using a wafer surface inspection system manufactured by YGK Corporation. As shown in FIGs. 8 and 9, it was confirmed that using the alkaline electrolyte solution demonstrated an excellent capacity to remove foreign matter from the processing surface W1. In other words, in the case of the salt water with the pH of 7, the zeta potential of the processing surface W1 is positive. In contrast, the zeta potential of foreign particles such as silica and ceria is negative. Therefore, an electrostatic attraction occurs between them. This promotes the foreign particles to adhere to the processing surface W1. In contrast, using the alkaline electrolyte solution causes the zeta potential of both the processing surface W1 and the foreign particles to become negative, causing an electrostatic repulsion between them. This effectively suppresses the foreign particles from adhering to the processing surface W1.

### (Summary of Examples)

Thus, according to the examples above, it was confirmed that the anodic oxidation using the alkaline electrolyte solution makes it possible to achieve both high processing speed and good quality. Specifically, the effect of improving the processing speed, efficiency, and quality was expressed in the pH range of 9 or more and 13 or less of the alkaline electrolyte solution.

### (Modifications)

This disclosure is not limited to the above embodiments. Therefore, modifications can be made to the above embodiments as appropriate. Typical modifications are described below. In the following description of the modifications, differences from the above embodiments are mainly explained. In the above embodiments and modifications, parts that are identical or equal to each other are marked with same signs. Therefore, in the description of the following modifications concerning the components having the same signs as in the above embodiments, the description in the above embodiments may be aided as appropriate unless there is a technical contradiction or a particular additional explanation.

The present disclosure is not limited to the specific device configuration shown in the above embodiments. In other words, FIG. 1 and the above description using it are simplified exclusively to explain the schematic configuration and functions of the surface processing apparatus 1 according to the present embodiment. Therefore, the surface processing apparatus 1 does not necessarily correspond to the specific equipment configuration that is actually manufactured and sold. Specifically, for example, in the above embodiment, the workpiece W is configured to be held in the container 2 and the surface processing pad 3 is configured to be rotatably held above the workpiece W. However, the present disclosure is not limited to such an aspect. For example, it may be configured to hold the workpiece W near a chuck located above the container 2 and rotary driven by the drive unit 4 and to hold the surface processing pad 3 near the container 2.

The electrolyte solution S may contain the etchant component. In other words, the surface processing method, according to the present disclosure, may be a method of polishing or grinding the processing surface W1 by selectively removing the oxide film formed by the anodic oxidation using both the etchant and the surface processing pad 3.

There are no particular restrictions on a type or size of the workpiece W. In other words, the technique of the present disclosure can be applied well to any workpiece W that can perform the surface planarization process with the anodic oxidation. The phrase "with the anodic oxidation" can also be expressed as "using the anodic oxidation." There are also no particular restrictions on a diameter when the workpiece W is a semiconductor ingot or wafer. The technique of the present disclosure can be applied well to the ingot and wafer with diameters in a range of 1 inch to 8 inch in size, in addition to the typical 6 inch in size.

There are no particular restrictions on a configuration of the surface processing pad 3, e.g., a surface roughness and material in the wheel layer 32. In other words, within a range where the effects of the present disclosure can be well obtained, details of the configuration of the surface processing pad 3 (e.g., the surface roughness and material in the wheel layer 32) can be selected from among those available.

Each element of the above embodiments is not necessarily essential as the element, except when expressly stated as particularly essential or when they are critical in principle, etc. When numerical values of the number, amount, range, etc., of the elements are described, the present disclosure is not limited to those values, except when expressly stated as particularly essential or when limited to a particular value in principle. Similarly, when the shape, orientation, positional relationship, etc., of the elements, etc., are described, the present disclosure is not limited to such shape, orientation, positional relationship, etc., except when expressly stated as particularly essential or when limited to a particular shape, orientation, positional relationship, etc., in principle.

The modifications are also not limited to the above description. For example, multiple embodiments, other than those described above, can be combined with each other as long as there is no technical contradiction therebetween. Similarly, multiple modifications can be combined with each other as long as there is no technical contradiction therebetween.

### (Aspect of Present Disclosure)

As is apparent from the description of the embodiments and modifications described above, at least the following aspects are disclosed herein.

### [Aspect 1]

A surface processing method for planarizing a processing surface (W1) of a workpiece (W), includes the following procedures, treatments, or processes:
with a wheel layer (32) and the processing surface of the workpiece facing each other with an alkaline electrolyte solution (S) between them, an oxide is formed on the processing surface of the workpiece by anodic oxidation by passing a current through the workpiece as an anode; and
the oxide formed on the processing surface by the anodic oxidation is removed by using the wheel layer.

### [Aspect 2]

The surface processing method is according to aspect 1, wherein a pH of the alkaline electrolyte solution is in a range of 9 or more and 13 or less.

### [Aspect 3]

The surface processing method is according to aspect 1 or 2, wherein the workpiece is a silicon-based material.

### [Aspect 4]

The surface processing method is according to aspect 3, wherein the workpiece is a silicon carbide semiconductor.

### [Aspect 5]

The surface processing method is according to any one of aspects 1 to 4, and further includes controlling each potential of the workpiece and of sludge by the anodic oxidation with the alkaline electrolyte solution to suppress agglomeration of the sludge, and the agglomeration of abrasive grains released from the wheel layer, as well as adhesion of the sludge to the processing surface.

### [Aspect 6]

The surface processing method is according to any one of aspects 1 to 5, and further includes reducing a hardness of the oxide film by the anodic oxidation with the alkaline electrolyte solution to be easily removed the oxide film using the wheel layer.

### [Aspect 7]

The surface processing method is according to any one of aspects 1 to 6, and further includes using the alkaline electrolyte solution for the anodic oxidation to improve a processing speed of a surface process.

### [Aspect 8]

The surface processing method is according to any one of aspects 1 to 7, and further includes using the alkaline electrolyte solution for the anodic oxidation to reduce a wear rate of the wheel layer.

### [Aspect 9]

The surface processing method is according to any one of aspects 1 to 8, wherein, removing the oxide film by using the wheel layer is grinding or polishing (i.e., rough grinding, finish grinding, rough polishing, or finish polishing).

## Claims

1. A surface processing method for planarizing a processing surface (W1) of a workpiece (W), comprising:
with a wheel layer (32) and the processing surface of the workpiece facing each other with an alkaline electrolyte solution (S) between them, forming an oxide on the processing surface of the workpiece by anodic oxidation by passing a current through the workpiece as an anode; and
by using the wheel layer, removing the oxide formed on the processing surface by the anodic oxidation.

2. The surface processing method according to claim 1, wherein,
a pH of the alkaline electrolyte solution is in a range of 9 or more and 13 or less.

3. The surface processing method according to claim 1 or 2, wherein,
the workpiece is a silicon-based material.

4. The surface processing method according to claim 3, wherein,
the workpiece is a silicon carbide semiconductor.

5. The surface processing method according to claim 1, wherein,
each potential of the workpiece and of sludge is controlled by the anodic oxidation with the alkaline electrolyte solution to suppress agglomeration of the sludge, suppress the agglomeration of abrasive grains released from the wheel layer, and suppress adhesion of the sludge to the processing surface.

6. The surface processing method according to claim 1, wherein,
a hardness of the oxide film is reduced by the anodic oxidation with the alkaline electrolyte solution to be easily removed the oxide film using the wheel layer.

7. The surface processing method according to claim 1, wherein,
the alkaline electrolyte solution for the anodic oxidation is used to improve a processing speed of a surface process.

8. The surface processing method according to claim 1, wherein,
the alkaline electrolyte solution for the anodic oxidation is used to reduce a wear rate of the wheel layer.

9. The surface processing method according to claim 1, wherein,
removing the oxide film by using the wheel layer is grinding or polishing.
